**Europäisches Patentamt**

**European Patent Office**

**Office européen des brevets**

(11) Veröffentlichungsnummer : **0 456 600 A1**

## (12) EUROPÄISCHE PATENTANMELDUNG

(21) Anmeldenummer : **91810273.2**

(22) Anmeldetag : **12.04.91**

(51) Int. Cl.[5] : **C23C 4/10, H01L 39/24**

(30) Priorität : **11.05.90 CH 1599/90**

(43) Veröffentlichungstag der Anmeldung :
**13.11.91 Patentblatt 91/46**

(84) Benannte Vertragsstaaten :
**CH DE FR GB IT LI NL**

(71) Anmelder : **PLASMA-INVENT AG**
**Oberleh 2**
**CH-6300 Zug (CH)**

(72) Erfinder : **Barbezat, Gerard**
**Müliwiesstrasse 39**
**CH-8487 Zell (CH)**
Erfinder : **Siegmann, Stephan**
**In den Klosterreben 64**
**CH-4052 Basel (CH)**

(74) Vertreter : **Rottmann, Maximilian R.**
**c/o Rottmann, Zimmermann + Partner AG**
**Glattalstrasse 37**
**CH-8052 Zürich (CH)**

(54) Verfahren zum Herstellen von dünnen Schichten aus supraleitender Mischkeramik.

(57) Für die Herstellung von Hochtemperatur-Supraleitern aus einer Mischkeramik, die als Spritzschicht auf ein Substrat mit Hilfe des thermischen HVC-Spritzverfahrens niedergeschlagen wird, wird während der Beschichtung das Substrat auf 700 bis 850° C gehalten und nach der Beschichtung mit einer Maximalgeschwindigkeit von 5° C/min langsam abgekühlt. Weiterhin erfolgen Beschichtung und Abkühlung unter Ueberdruck in einer mindestens 50 Vol.% Sauerstoff enthaltenden Gasatmosphäre.

Durch die geschilderten Massnahmen werden Sprungtemperaturen $T_c$ über 77 K und Stromdichten $J_c$ von etwa 100 A/cm$^2$ erreicht, ohne dass die supraleitende Schicht einer thermischen Nachbehandlung unterzogen werden muss.

EP 0 456 600 A1

Die Erfindung betrifft ein Verfahren zum Herstellen von dünnen Schichten aus supraleitender Mischkeramik, z. B. aus $Y_1Ba_2Cu_3O_x$ mit einem Sauerstoffanteil x von mindestens 6,7, durch Hochgeschwindigkeits-Flammspritzen (HVC).

Es ist bekannt, relativ dicke Schichten - mit Schichtdicken grösser 10 µm bis etwa zu 200 µm - von keramischen Hochtemperatur-Supraleitern, die Sprungtemperaturen $T_c$ über dem Siedepunkt von flüssigem Stickstoff, also höher als 77 K, und Stromdichten $J_c$ von etwa 100 A/cm² haben, und die eine ausreichende Bruchfestigkeit besitzen, als Spritzschichten durch thermisches Spritzen herzustellen. Als ein besonders geeignetes Verfahren dafür hat sich das sogenannte Hochgeschwindigkeits-Flammspritzen (HVC) bewährt (G.Barbezat et al "Die neuen Supraleiter als Spritzschicht" Sulzer Technische Rundschau 1/1990, Seite 13-16).

Das HVC-Verfahren ist ein in den letzten Jahren entwickeltes Flammspritzverfahren, bei dem die Spritzpartikel Geschwindigkeiten erreichen, die über der Schallgeschwindigkeit liegen (siehe z.B. Sulzer Technische Rundschau (STR) 4/1988, Seite 4-10).

Um die vorstehend genannten Eigenschaften der supraleitenden Schichten zu erreichen, ist es bisher erforderlich, die flammgespritzten Schichten anschliessend in Anwesenheit von Sauerstoff einer Wärmebehandlung zu unterziehen, bei der Substrat und Schicht zunächst auf 800 bis 950° C erwärmt und anschliessend langsam abgekühlt werden. Bei dieser Wärmebehandlung diffundiert Sauerstoff in die Schicht hinein, wobei sowohl die für die hohe Sprungtemperatur notwendige Kristallstruktur erzeugt, als auch die dafür notwendige, relativ hohe Sauerstoffkonzentration in dieser Schicht erreicht werden; bei einer Mischkeramik aus $Y_1Ba_2Cu_3O_x$ wird durch die thermische nachbehandlung der Sauerstoffanteil auf etwa 6,8 bis 6,9 erhöht, wobei gleichzeitig die bekanntlich für die hohe Sprungtemperatur notwendige orthorhombische Kristallstruktur entsteht bzw. vervollkommnet wird.

Eine nachbehandlung der Schicht ist jedoch zeitraubend und aufwendig. Aufgabe der Erfindung ist es daher, das bekannte HVC-Verfahren zum Herstellen von hochtemperatursupraleitenden Schichten derart zu verbessern, dass die Schichten die geforderten Eigenschaften bereits im Spritzzustand haben.

Diese Aufgabe wird nach dem neuen Verfahren dadurch gelöst, dass
- das die supraleitende Schicht tragende Substrat während der Beschichtung bis zu deren Erstarren auf einer Temperatur zwischen 700 und 850 °C gehalten wird,
- die Beschichtung und die Abkühlung der erzeugten Schicht in einer Gasatmosphäre mit einem Sauerstoff($O_2$)-Anteil von mindestens 50 Vol % bei einem Überdruck von 0.05 bis 0.5 bar durchgeführt werden, und

- bei Temperaturen oberhalb von mindestens 400 °C eine Abkühlgeschwindigkeit von höchstens fünf Grad C pro Minute (5 °C/min) eingehalten wird.

Bei Temperaturen unter 700° C ist die Diffusion - die bekanntlich eine Funktion von Zeit und Temperatur ist - des Sauerstoffes zu gering, um eine ausreichende Erhöhung des Sauerstoffanteils in der Kristallstruktur zu erreichen, obwohl der Sauerstoff gegenüber einer Luftatmosphäre im Ueberschuss "angeboten" wird. Temperaturen über 850° C können die Festigkeit der Schicht beeinträchtigen. Der Sauerstoffüberschuss, der vorzugsweise bis zu einem Sauerstoff-Anteil von mindestens 80 Vol.%, insbesondere von 90 Vol.%, erhöht werden kann und der Sauerstoffüberdruck bewirken, dass der Sauerstoffanteil in der sich absetzenden Kristallstruktur gesteigert wird und bei der erwähnten Schicht aus $Y_1Ba_2Cu_3O_x$ mindestens nahezu dem optimalen Wert von x = 7 erreicht. Die Grenzen des Ueberdruckes sind dabei einerseits durch den erforderlichen Minimalfluss an frischem Sauerstoff und andererseits durch die gerade noch zulässige, durch den Sauerstoffstrom bewirkte Abkühlung bestimmt.

Wie erwähnt, sind die Diffusion des Sauerstoffes in die Kristallstruktur hinein und seine Verteilung in ihr eine Funktion von Temperatur und Zeit. Um für diese Vorgänge ausreichend Zeit "zur Verfügung zu stellen", wird die Abkühlgeschwindigkeit pro Minute für das beschichtete Substrat bei Temperaturen oberhalb von 400°C begrenzt; sie beträgt vorteilhafterweise 3° C/min. Unterhalb von 400° C kann die Abkühlgeschwindigkeit bis zu 20° C/min erhöht werden.

Das Aufheizen des Substrates kann beispielsweise durch eine elektrische Heizung erfolgen, deren Heizstrom aufgrund einer Temperaturmessung am Substrat geregelt wird, um sowohl die gewünschte Substrattemperatur als auch die genannte Abkühlgeschwindigkeit einhalten zu können.

Weiterhin hat es sich als zweckmässig erwiesen, wenn das während des Beschichtens zuzuführende Gas für die Aufrechterhaltung eines leichten Ueberdruckes an sauerstoffreicher Gasatmosphäre auf eine Temperatur bis zu 300° C wird. Durch diese Aufheizung wird die durch den Gasstrom verursachte Abkühlung reduziert.

Als Ausgangsmaterial für die Beschichtung hat sich als am geeignetsten ein Pulver der stöchiometrischen Zusammensetzung $Y_1Ba_2Cu_3O_7$ mit Partikelgrössen von 10 bis 80 µm herausgestellt, das im Handel erhältlich ist.

Im folgenden wird die Erfindung anhand eines Ausführungsbeispiel näher erläutert; in diesem wird ein KeramikSubstrat mit einer supraleitenden Schicht aus der Mischkeramik $Y_1Ba_2Cu_3O_x$ beschichtet.

Zunächst wird das Substrat als Plasmaspritzschicht mit Hilfe eines bekannten Plasmaspritzverfahrens, das in Luft ausgeführt wird, auf einen Metallkörper, beispielsweise aus Stahl, aufgebracht, wobei gegebenenfalls zwischen dem Metallkörper und der Keramikschicht eine ebenfalls in Luft plasmagespritzte Haftschicht aus NiCrAlY von 50 µm "eingeschoben" wird. Das Substrat aus Keramik haftet dabei beispielsweise an einem Stahlplättchen von 1,5 mm Dicke und hat selbst eine Dicke von 0,2 mm.

Der Stahl-Keramik-Verbundkörper wird dann mit dem Substrat nach aussen in einem Metallblock relativ grosser Masse, beispielsweise aus Kupfer, versenkt und mit ihm verbunden; dieser Block kann elektrisch beheizt werden. Mit seiner relativ grossen Masse bildet der Metallblock für Substrat und aufzubringende supraleitende Schicht einen Thermostaten.

Am das Substrat tragenden Metallplättchen ist darüberhinaus ein Temperaturfühler vorgesehen, der die Temperatur des Substrates erfasst und in ihrer Abhängigkeit den Heizstrom der Heizung für den Kupferblock so steuert, dass sowohl die gewünschten Substrattemperaturen als auch die geforderten Abkühlgeschwindigkeiten eingehalten werden.

Auf das so vorbereitete Substrat, das beispielsweise aus einer Mischung von Zirkonoxid mit 8 Gew.% Ytriumoxid ($ZrO_2/8Y_2O_3$) besteht, wird nun mit Hilfe des HVC-Verfahrens eine supraleitende Schicht aufgespritzt, wofür das Substrat zunächst in einer von der Umgebung weitgehend abgeschirmten Spritzkammer deponiert und durch Aufheizung des Metallblockes auf eine Temperatur von etwa 800° C aufgeheizt wird; in der Spritzkammer wird dabei ein Ueberdruck von 0,1 bar einer sauerstoffreichen Atmosphäre mit einem Volumen-Anteil des Sauerstoffes von nahezu 100 % während des Spritzvorganges bis zum Erstarren der Spritzschicht und während der Abkühlung des beschichteten Substrates auf Temperaturen unter 400° C aufrechterhalten.

Ueberdruck und Gaszusammensetzung werden durch kontinuierliches Einblasen eines Stromes von 5 1/min eines Gases aus nahezu 100 Vol.% Sauerstoff gewährleistet. Als Spritzpulver für das Flammspritzverfahren dient im Handel erhältliches Pulver der stöchiometrischen Zusammensetzung $Y_1Ba_2Cu_3O_7$, bei dem die Partikelgrössen vorzugsweise zwischen 20 und 60 µm betragen.

Das Aufbringen der Schicht erfolgt in einer bekannten Anlage; als Brenngas dient dabei ein Sauerstoff/Propan/Gemisch mit einem Sauerstoff/Propan-Verhältnis von 8 bis 12, insbesondere von 10, das in einem Strom von etwa 500 1/min eingesetzt wird. Als Trägergas für die Pulverinjektion wird Stickstoff in einem Strom von 25 1/min verwendet.

Das $Y_1Ba_2Cu_3Y_7$-Pulver wird in einer Menge von 20 g/min in den Gasstrahl eingebracht, wobei Geschwindigkeiten zwischen substrat- und pulvertragenden Gasstrahl von 1500 m/sec erreicht werden.

Der Abstand zwischen Spritzanlage und Substrat beträgt 300 bis 350 mm.

Der Spritzvorgang, bei dem die Spritzpistole von einem Manipulator oder Roboter gesteuert, die zu beschichtende Oberfläche zeilenweise überstreicht, wird aufrechterhalten bis eine Schichtdicke von etwa 50 bis 100 µm erreicht ist.

Nach Erreichen der geforderten Schichtdicke verbleibt das beschichtete Substrat zunächst in der Spritzkammer, in die weiter sauerstoffreiches Gas eingeblasen wird. Durch gesteuerte Reduktion des Heizstromes lässt man Schicht und Substrat, d.h. den ganzen Metallblock, in den beide eingebettet sind, mit einer Geschwindigkeit von 3° C/min langsam abkühlen, bis eine Temperatur unter 400° C erreicht ist. Die weitere Abkühlung auf Raumtemperatur erfolgt, ebenfalls durch den Heizstrom gesteuert, mit einer höheren Geschwindigkeit, die maximal 20° C/min beträgt.

Anschliessende Untersuchungen haben gezeigt, dass die mechanischen Eigenschaften der Schicht denjenigen entsprechen, die bei dem eingangs geschilderten Verfahren erreicht werden. Messung der Sprungtemperatur $T_c$ und der Stromdichte $Y_c$ ergaben, wie gefordert, Werte über 77 K bzw. 100 A/cm². 

Weitere Untersuchungen haben ergeben, dass in der Schicht eine orthorhomische Kristallstruktur vorliegt, bei der die Zusammensetzung der Mischkeramik und insbesondere der Sauerstoff-Anteile mindestens nahezu der stöchiometrischen Zusammensetzung $Y_1Ba_2Cu_3O_7$ entspricht.

**Patentansprüche**

1. Verfahren zum Herstellen von dünnen Schichten aus supraleitender Mischkeramik, z. Beispiel aus $Y_1Ba_2Cu_3O_x$ mit einem Sauerstoffanteil x von mindestens 6,7, durch Hochgeschwindigkeits-Flammspritzen (HVC), dadurch gekennzeichnet, dass

   – das die supraleitende Schicht tragende Substrat während der Beschichtung bis zu deren Erstarren auf einer Temperatur zwischen 700 und 850 °C gehalten wird,
   – die Beschichtung und die Abkühlung der erzeugten Schicht in einer Gasatmosphäre mit einem Sauerstoff($O_2$)-Anteil von mindestens 50 Vol % bei einem Überdruck von 0.05 bis 0.5 bar durchgeführt werden, und
   – bei Temperaturen oberhalb von mindestens 400 °C eine Abkühlgeschwindigkeit von höchstens fünf Grad C pro Minute (5 °C/min) eingehalten wird.

2. Verfahren nach Anspruch 1, dadurch gekennzeichnet, dass der Sauerstoff-Anteil der Gasatmosphäre mindestens 80 Vol.%, insbesondere 90 Vol %, beträgt.

3. Verfahren nach Anspruch 1 oder 2, dadurch gekennzeichnet, dass die Abkühlungsgeschwindigkeit pro min zwischen 1 und 5, insbesondere 3, °C beträgt.

4. Verfahren nach einem der Ansprüche 1 bis 3, dadurch gekennzeichnet, dass unter 400 °C eine Abkühlgeschwindigkeit von höchstens 20 °C eingehalten wird.

5. Verfahren nach einem der Ansprüche 1 bis 4, dadurch gekennzeichnet, dass das zuzuführende Gas auf höchstens 300 °C vorgeheizt wird.

6. Verfahren nach einem der Ansprüche 1 bis 5, dadurch gekennzeichnet, dass als Ausgangsmaterial ein Pulver der stöchiometrischen Zusammensetzung $Y_1Ba_2Cu_3O_7$ verwendet wird.

7. Verfahren nach einem der Ansprüche 1 bis 6, dadurch gekennzeichnet, dass als Ausgangsmaterial Pulver mit Partikelgrösse von 10 bis 80 µm verwendet werden.

8. Verfahren nach einem der Ansprüche 1 bis 7, dadurch gekennzeichnet, dass die Beschichtung durchgeführt wird, bis die Dicke der supraleitenden Schicht zwischen 10 und 200 µm beträgt.

9. Supraleitende Schicht hergestellt nach einem der Ansprüche 1 bis 8, dadurch gekennzeichnet, dass ihre Sprungtemperatur $T_c$ über 77 K liegt.

Europäisches
Patentamt

**EUROPÄISCHER RECHERCHENBERICHT**

Nummer der Anmeldung

EP 91 81 0273

| | EINSCHLÄGIGE DOKUMENTE | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
| A | WO-A-8 908 332 (SIEMENS) * Patentansprüche 1-5; Seite 2, Zeilen 15-18; Seite 3, Zeilen 7-17 * --- | 1,2,6,9 | C 23 C 4/10 H 01 L 39/24 |
| A | APPLIED PHYSICS LETTERS, Band 54, Nr. 13, 27. März 1989, Seiten 1275-1277, New York, US; T. ASANO: "Interface analysis of Y-Ba-Cu-O films on Al-coated substrates" * Seite 1275 * --- | 1,3,4,6 ,8 | |
| A | APPLIED PHYSICS LETTERS, Band 52, Nr. 12, 21. März 1988, Seiten 1011-1013, New York, US; K. TACHIKAWA: "High Tc superconducting films of Y-Ba-Cu oxides prepared by low-pressure plasma spraying" * Seite 1011 * --- | 1,6,7,8 | |
| A | EP-A-0 288 711 (IBM) * Seite 5, Zeilen 6-18; Seite 9, Zeilen 7-14 * --- | 1,2,6,7 ,8 | RECHERCHIERTE SACHGEBIETE (Int. Cl.5) |
| A | EP-A-0 302 506 (HITACHI) * Figur 4c; Spalte 6, Zeile 36; Patentanspruch 1 * ----- | 1,6 | C 23 C H 01 L |

Der vorliegende Recherchenbericht wurde für alle Patentansprüche erstellt

| Recherchenort | Abschlußdatum der Recherche | Prüfer |
|---|---|---|
| DEN HAAG | 07-08-1991 | ELSEN D.B.A. |